Europäisches Patentamt

European Patent Office

Office européen des brevets

(11) Publication number: **0 431 694 A1**

# EUROPEAN PATENT APPLICATION

(21) Application number: 90203181.4

(51) Int. Cl.5: **H04H 1/00, H03J 7/18**

(22) Date of filing: 03.12.90

(30) Priority: 07.12.89 NL 8903012

(43) Date of publication of application:
12.06.91 Bulletin 91/24

(84) Designated Contracting States:
AT CH DE FR GB IT LI SE

(71) Applicant: N.V. Philips' Gloeilampenfabrieken
Groenewoudseweg 1
NL-5621 BA Eindhoven(NL)

(72) Inventor: Kamalski, Theodor Ignatius Eduard
c/o INT. OCTROOIBUREAU B.V., Prof.
Holstlaan 6
NL-5656 AA Eindhoven(NL)

(74) Representative: Schoonheijm, Harry Barend et
al
INTERNATIONAAL OCTROOIBUREAU B.V.
Prof.Holstlaan 6
NL-5656 AA Eindhoven(NL)

(54) FM receiver for radio data signals.

(57) FM receiver for radio data signals comprising digital tuning data of alternative frequencies of a plurality of transmitters, which receiver comprises a first memory circuit for storing the digital tuning data of at least a part of the alternative frequencies, and a tuning control circuit which sets the tuning of the FM receiver at one of the frequencies in the first memory circuit when a first activation signal is applied. In order to realise fast tuning to a desired program within a large region, for example a country, the FM receiver according to the invention comprises an arrangement for determining the number of alternative frequencies of each one of said transmitters and for selecting those transmitters whose number of alternative frequencies exceeds a threshold value, and a second memory circuit for storing the tuning data of the last-mentioned transmitters, said tuning control circuit setting the tuning of the FM receiver at one of the frequencies whose tuning data are stored in the second memory circuit when a second activation signal is applied.

FIG.1

EP 0 431 694 A1

## FM RECEIVER FOR RADIO DATA SIGNALS.

The invention relates to an FM receiver for radio data signals comprising digital tuning data of alternative frequencies of a plurality of transmitters, which receiver comprises a first memory circuit for storing the digital tuning data of at least a part of the alternative frequencies and a tuning control circuit which sets the tuning of the FM receiver at one of the frequencies in the first memory circuit when a first activation signal is applied.

An FM receiver of this type is, for example, the Philips car radio of the type DC 682 which was marketed recently.

This known FM receiver has a plurality of keys for tuning to preset programs - also referred to as preselection tuning keys. With the aid of each key, one of a plurality of memory circuits or memory banks can be activated each time, which memory banks are used for storing, inter alia tuning data or frequencies of transmitters broadcasting these preset programs.

When the FM receiver is installed for the first time or when the preselection tuning keys are reprogrammed, the FM receiver is first tuned to a transmitter with a desired program by means of a manually operated tuning control member and subsequently one of the preselection tuning keys is pressed for some time. If the transmitter to which the FM receiver is tuned - hereinafter referred to as actual transmitter - is not an RDS transmitter, only its frequency is stored in the memory bank activated by the depressed tuning key, and frequencies of other transmitters carrying the same program can be manually stored in this memory bank in a similar manner. Thus, the tuning keys can be provided one by one with a list of frequencies of transmitters carrying the same program for each tuning key - hereinafter also referred to as formatting the tuning keys. For non-RDS transmitters a format once chosen can only be modified manually.

If the actual transmitter is an RDS transmitter, formatting proceeds automatically after one of the tuning keys has been pressed for some time. Not only is the frequency of the actual transmitter stored in the relevant memory bank, but also the list of AFs (alternative frequencies, or frequencies of transmitters broadcasting the same program or a program which is an alternative to the program of the actual transmitter) transmitted along with the RDS signal of the actual RDS transmitter, PI (program identification) code, the PS (program service) name and possible other digital program data. Similarly, the other tuning keys can be automatically formatted after tuning to an RDS transmitter with a given desired program. For a further description of the abbreviations AF, PI and PS reference is made to the EBU document "Section V - Baseband Coding" of March 1987.

After formatting, the programs allocated to the tuning keys can be simply recalled by pressing the relevant tuning key for a short time. Since the storage capacity of the memory banks is not unlimited, it may occur that only a part of the received alternative frequencies can be stored in the memory banks. To this end a selection is performed of the reception quality of the FM signal at these alternative frequencies and those having a higher reception quality are stored. The list of transmitter frequencies in each memory bank is continuously monitored for reception quality so that it is known at any moment which other transmitter trails the actual transmitter in reception quality. The tuning can be immediately switched to this other transmitter if its reception quality becomes better than that of the actual transmitter, for example, if the FM receiver implemented as a car radio is further remote from the actual transmitter and closer to said other transmitter.

The actual transmitter frequency thus varies with the location of the FM receiver and, in the case of RDS reception, also the AF list in the activated memory bank of the last selected tuning key varies, so that the receiver of a user driving through a comparatively large region is continuously tuned to the frequency of the best receivable transmitter carrying the program allocated to said tuning key. The AF lists in the non-active memory banks of the other preselection tuning keys do not vary, however. When switching programs by pressing another tuning key it may, however, occur that a satisfactory reception of any transmitter in the AF list of the memory bank activated by this other tuning key is impossible, because this list of AFs relates to a region which is far remote from the actual receiver location. This may of course also occur if one has covered a large distance with the car radio switched off and if one subsequently switches it on to a given program.

In that case automatic search tuning starts, performing a sequential tuning to all FM transmitters and searching for receivable FM-RDS transmitters with a PI code in the RDS signal, which code corresponds to the PI code stored in the active memory bank. Due to the RDS and PI check which must be performed on each receivable FM transmitter, it takes a comparatively long time before an RDS transmitter with the desired PI code is found by means of this so-called PI search tuning. Once such a transmitter has been found, the active memory bank is filled with the AF list transmitted by this transmitter. When switching over to another program, this process may be repeated again.

It is an object of the invention to provide an FM-RDS receiver enabling the user to tune to a transmitter with a desired program at a must faster rate than is possible with PI search tuning, if the receiver location is outside the region of the AFs stored under the tuning keys.

According to the invention an FM-RDS receiver of the type described in the opening paragraph is therefore characterized by an arrangement for determining the number of alternative frequencies of each one of said transmitters and for selecting those transmitters whose number of alternative frequencies exceeds a threshold value, and a second memory circuit for storing the tuning data of the last-mentioned transmitters, said tuning control circuit setting the tuning of the FM receiver at one of the frequencies whose tuning data are stored in the second memory circuit when a second activation signal is applied.

The invention utilises the fact that in a comparatively large region such as, for example, the territory of a country like the Federal Republic of Germany a comparatively small number of transmitters can be allocated, which transmitters will hereinafter be referred to as main transmitters, whose total transmission range covers this territory throughout. As far as their numbers are concerned, these transmitters only form a very small part of the total number of transmitters operating in this territory, but their location and transmission range are spread over said territory in such a way that at least one of them can be received with a more or less acceptable reception quality from substantially any location in this territory.

The invention is based on the recognition that said main transmitters can be recognised by the comparatively large number of associated alternative frequencies, or by the comparatively large number of AF lists of other transmitters, hereinafter referred to as auxiliary transmitters, in which the frequencies of these main transistors occur as alternative transmitter frequencies.

When using the measure according to the invention, that (those) transmitter(s) is (are) searched in each partial region of a larger uninterrupted geographical region which with respect to the other transmitters in that partial region has (have) the largest number of AFs or at least a number of AFs which is larger than the average number per transmitter. These transmitters are considered as main transmitters and for their selection use can be made of a fixed preselected threshold value for the number of AFs or of a threshold value which varies with the number of transmitters in the relevant partial region. The main transmitter(s) thus selected for each partial region is (are) subsequently stored in the further memory circuit and constitute(s) a so-called emergency list of transmitter frequencies for the entire geographical region covering the partial regions. This emergency list is consulted or activated when the memory bank under a given tuning key does not comprise any receivable alternative frequency when the receiver is switched on. The FM receiver is then immediately tuned to the best receivable transmitter frequency in this emergency list. The period of time required for this purpose is negligibly short as compared with the period of time for PI search tuming. Subsequently, the relevant memory bank is filled with the list of AFs of the last-mentioned transmitter frequency and the tuning is possibly switched over to the best receivable AF in this AF list.

A preferred embodiment of such an FM-RDS receiver is characterized in that the detection circuit also measures the reception quality of the FM signal at the frequencies whose tuning data are stored in the second memory circuit when the second activation signal is applied, and the tuning circuit sets the tuning of the FM receiver at the frequency in the second memory circuit having the highest reception quality.

As is known from the above-mentioned EBU documentation, the AFs can be transmitted in accordance with the so-called version A or the so-called version B. In both versions the AFs are pairwise transmitted in two-column lists, preceded by a header stating the total number of AFs in the list, also referred to as length indication, and the tuning data of the actual transmitter frequency. In version A only the associated AF list, i.e. the AF list of the actual transmitter frequency is transmitted per transmitter. This list may comprise a maximum number of 25 different transmitter frequencies. In version B not only the AF list associated with the actual transmitter frequency is transmitted per transmitter, but also so-called AF sublists associated with non-actual transmitter frequencies in a fairly large region around or adjoining the region to which said AF list relates. Moreover, two successive lists are transmitted for transmitters with more than 12 alternative frequencies. The region of the transmitters relating to the AFs transmitted in accordance with version A is therefore considerably smaller than the region of the transmitters relating to AFs transmitted in accordance with version B.

Consequently, if the AFs are transmitted in accordance with version A, the invention can only be used after the FM receiver has been tuned in each partial region to the programs allocated to the tuning keys. For use of the invention in case the AFs are transmitted in accordance with version B and already when tuning to one of the transmitters in a large region, for example, a country like Germany, the tuning data of all main transmitters can be derived from the AF lists received via this transmitter.

A preferred embodiment of an FM-RDS receiver according to the invention is therefore characterized in that said arrangement also determines the method of transmitting the alternative frequencies and comprises means for deriving the number of alternative frequencies per transmitter from the length indications which are incorporated per transmitter in the headers of the alternative frequency lists in the RDS signals.

When using this measure the best receivable AF from the emergency list is known at any moment so that it is possible to tune to this AF immediately.

In another preferred embodiment the FM receiver according to the invention is realised by means of a plurality of microprocessors which are programmed in such a way that said threshold value is fixed during filling of the second memory circuit and, when the second memory circuit is completely filled, is equal to the smallest number of alternative frequencies in the second memory circuit, the tuning data of a transmitter selected by said arrangement and the number of alternative frequencies thereof being stored at the location of the transmitter with said smallest number of alternative frequencies when the second memory circuit is completely filled.

The invention will now be described in greater detail by way of example with reference to the Figures shown in the drawings, which Figures only serve to illustrate the invention.

In the drawings:

Fig. 1 shows an FM-RDS receiver according to the invention;

Fig. 2 shows a flow chart of a method of selecting tuning data to be stored in an emergency list of main transmitters in said country;

Fig. 3 shows diagrammatically a header of an AF list;

Fig. 4 shows diagrammatically the emergency list of transmitters stored in the second memory circuit.

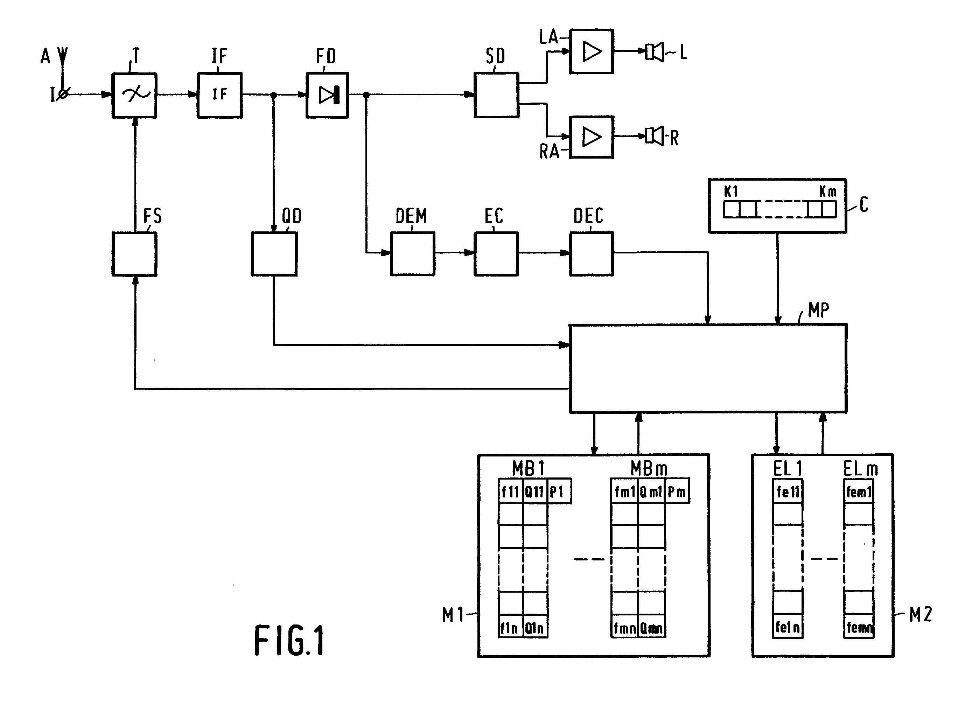

Fig. 1 shows an FM-RDS receiver according to the invention, based on the known Philips FM-RDS receiver of the type DC 682. The FM-RDS receiver shown has an antenna input I via which an antenna A is successively coupled to an RF input and tuning circuit T for tuning to and frequency conversion of an RF-FM-RDS signal to an intermediate frequency, an IF section IF for selecting and amplifying the IF-FM-RDS signal, a frequency detector FD for detecting the baseband modulation signal, a stereo decoder SD for decoding a stereo multiplex signal in left and right stereo signals in the case of a stereophonic FM modulation signal, left and right audio amplifiers LA and RA succeeded by loudspeakers L, and R, respectively, for amplifying and reproducing the stereo signals.

The IF section IF is also coupled to a detection circuit QD for measuring the reception quality of the RF-FM signal to which the FM receiver is tuned. The reception quality is derived in known manner from effects in the non-limited FM-IF signal caused by multipath reception and field strength. The detection circuit QD supplies an indication of the reception quality to a microprocessor circuit MP to be described hereinafter.

The frequency detector FD is also successively coupled to an RDS demodulator DEM for selecting and demodulating the RDS signal, an error correction and clock synchronising circuit EC and an RDS decoder circuit DEC for decoding the digital RDS signal. The RDS decoder circuit DEC supplies the received digital RDS information to the microprocessor circuit MP.

The microprocessor circuit MP is connected to a tuning control unit C and to at least a first memory circuit M1 via a multiple connection. The tuning control unit C is provided with program preselection tuning keys K1 to Km which correspond to memory banks MB1 to MBm, respectively, of the first memory circuit M1 and are used to activate these banks via the microprocessor circuit MP.

The microprocessor circuit MP is also coupled to a frequency synthesis circuit FS which is connected to the RF input and tuning circuit T for automatic control of the FM receiver tuning. The frequency synthesis circuit FS is also provided with means (not shown) for manually operated receiver tuning. The microprocessor circuit MP is programmed in such a way that it functions as an arrangement for, inter alia:

- so-called formatting or programming of the tuning keys K1 to Km, allocating a number of m programs p1 to pm, respectively, to these tuning keys. To this end the microprocessor circuit MP stores the tuning data or frequencies of a maximum number of n transmitters with, for example, program p1 at memory sites f1 to fn of the memory bank MB1, and so forth, up to and including a number of n transmitters with program pm at memory sites fm1 to fmn of the memory bank MBm. If RDS signals are received, this so-called filling of the frequency lists per program is effected automatically in such a way that the frequency of the n best receivable transmitters are stored per program in these frequency lists. In the foregoing example the so-called PI code of the transmitters f11 to f1n is stored at a memory site P1 of the memory bank MB1, possibly together with other codes, as well as the PI code of f21 to f2n, etc. at memory site P2 of MB2;
- sequentially tuning the FM receiver for an inaudibly short time to, inter alia each of the frequencies in the memory banks MB1 to MBm in order to monitor these frequencies more or less continuously for reception quality. To this end an indication of the reception quality of the transmitters f1 to fn supplied by the detection circuit QD is stored and continuously updated at memory sites Q1 to Qn which are associated with the memory sites f1 to fn of each one of the memory banks MB1 to MBm;
- when changing the tuning, the frequency list of the active memory bank is automatically filled with the AF list and the program data of the then actual transmitter;
- continuously determining at which frequency in the frequency list of the desired program an optimum signal reception is possible and automatically tuning the FM receiver thereto.

In order to enable automatic programming and updating of the frequency lists, both when programs and actual transmitters are changed, independent of the way in which the AFs occur in the received RDS signal, i.e. when using the so-called version A as well as the so-called version B for the transmission of the AFs, the microprocessor MP tests properties which are specific of these versions. Version A is recognised because the actual transmitter frequency only occurs in the header of the AF list, together with a length indication of the AF list and because the frequencies in successive frequency blocks or frequency pairs mutually deviate. Version B is recognised because the actual transmitter frequency is repeated per frequency pair and because not only a length indication of the AF list but also the frequency of this transmitter is repeated in the headers of AF lists associated with one and the same transmitter. It is further to be noted that only the AF list associated with the actual transmitter is transmitted when using version A, while in addition to the AF list associated with the actual transmitter also the AF lists of the transmitters occurring in the AF list of the actual transmitter (hereinafter referred to as AF sublists) as well as the sublists of the transmitters in said AF sublists, etc. are transmitted when using version B. When tuning to an RDS transmitter, the tuning data or frequencies of alternative transmitters are received in a region which is much smaller in the case of version A than in the case of version B. When tuning to an RDS transmitter which transmits AF information in accordance with version B, the tuning data of alternative frequencies are received in a large uninterrupted region or country such as, for example the Federal States of the Federal Republic of Germany, or Austria.

For further information about these versions A and B reference is made to the above-mentioned EBU document.

The structure and operation of the FM-RDS receiver according to the invention described so far corresponds to said known Philips FM RDS receiver DC 682. For a further elaboration reference is made to the manual of this known receiver.

In addition to the known receiver, the FM-RDS receiver according to the invention comprises a second memory circuit M2 with memory banks EL1 to ELm which are associated with the memory banks MB1 to MBm, respectively, of the first memory circuit M1. This means that the memory banks EL1 to ELm are used for storing the tuning data or frequencies of certain transmitters, to be described hereinafter, which broadcast programs whose PI codes correspond to the PI codes P1 to Pm, respectively, of the transmitters whose tuning data or frequencies are stored in the memory banks MB1 to MBm. The memory banks EL1 to ELm each have a number of n memory sites fe1 to fen for storing frequencies fe11-fe1n to fem1-femn of transmitters whose number of alternative frequencies is comparatively large, i.e. a number exceeding a given threshold value. After determining the version used for the transmission of the AFs, the number of alternative frequencies at which a program or its alternative identical to the program of the transmitter mentioned in the header is transmitted, is computed by the microprocessor MP with reference to the length indication which is stated in the header of each received AF list.

In version A a length indication l in the header means that the actual transmitter has (l-1) alternative frequencies. In version B such a length indication means that the transmitter, in which the tuning data or the frequency is mentioned in the header, has (l-1)/2 alternative frequencies. If various successive AF lists are transmitted for a transmitter, the numbers of AFs for each list can be added together.

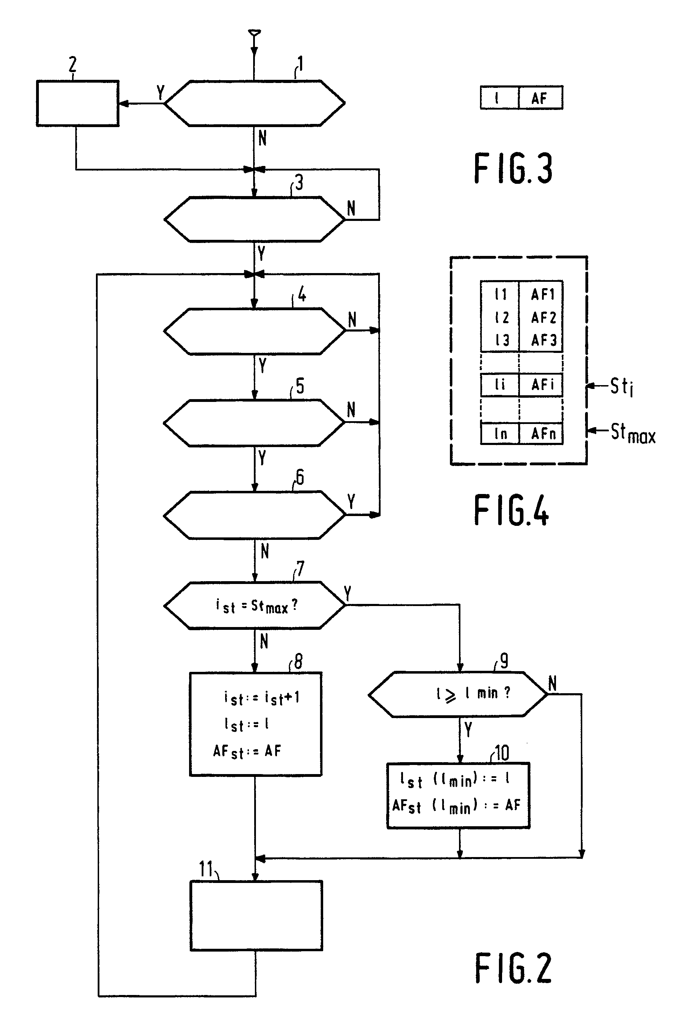

After determining the number of AFs for each transmitter frequency, this number is compared with said given threshold value in the microprocessor circuit MP. As stated hereinbefore, the transmitters whose number of AFs exceeds this threshold value - hereinafter referred to as main transmitters - with programs having PI codes P1 to Pm are stored in the memory banks EL1 to ELm, respectively, possibly together with the number of the associated AFs and/or an indication about the reception quality. In order to do this for a large uninterrupted region, it is necessary in version A to tune the FM receiver at least once to an RDS transmitter for each program in all partial regions within this uninterrupted region. In version B it is sufficient to tune once to an FM-RDS transmitter for each program within the last-mentioned region. The threshold value may be a fixed selected figure which is chosen to be equal, for example, to the average number of AFs of the transmitters carrying one and the same program. Alternatively the threshold value may vary, which takes place, for example in the case of a continuous optimisation of the selection of said main transmitters. Then there is a continuous search for transmitter frequencies having more AFs than the transmitter frequencies already stored in the memory banks EL1 to ELm. If a transmitter frequency, for example $f_y$ with PI code PI and $(n+1)$ AFs is found, while, for example the transmitter frequency f1i in the relevant memory bank EL1 with n AFs has the smallest number of AFs, the latter transmitter frequency f1i is replaced by $f_y$. The threshold value then increases from n to $n+1$. A functional flow chart to elucidate such a continuous selection optimisation is shown in Fig. 2.

The transmitters whose tuning data are mentioned in the respective memory banks MB1-MBm of the first memory circuit M1 are located in a comparatively small region around the location of the actual or last actual transmitter, and upon activation of the relevant memory bank they are continuously updated in dependence upon the receiver location. In contrast thereto, the main transmitters whose tuning data or frequency is mentioned in the respective memory banks EL1-ELm - hereinafter also referred to as emergency lists - are located in a much larger region and can be received with an acceptable reception quality. The main transmitters in these emergency lists substantially do not change with the receiver location.

Activation of a given memory bank MBx of the first memory circuit M is achieved by means of a first activation signal applied to the tuning control circuit, which activation signal is generated when a preselection tuning key is operated. The receiver location may be outside the region of the transmitters whose frequencies are stored in this memory bank MBx and none of these transmitters can be received with an acceptable reception quality. The microprocessor circuit MP then carries out a search action for a main transmitter in the emergency list ELx which is associated with the memory bank MBx, i.e. with a program corresponding to that of the transmitters in MBx which can be received with an acceptable reception quality. Subsequently the FM receiver is tuned to this main transmitter when a second activation signal is applied to the tuning control circuit. The second activation signal may be entered by the user or it may be automatically generated by the microprocessor circuit MP after a usable transmitter has been found in the emergency list ELx. An AF list is received via the last-mentioned main transmitter, which list is stored in the memory bank MBx and whose AF reception quality is tested. After determining the AF having the best reception quality in the last-mentioned AF list, the microprocessor circuit MP tunes the FM receiver to this AF which thereby becomes the actual transmitter.

Fig. 2 shows a functional flow chart to illustrate the operation of the microprocessor circuit in the case of a continuous optimisation of the selection of said main transmitters, starting from a transmission of AFs in accordance with version B.

After the receiver has been switched on, or when the preselection tuning is changed, the microprocessor circuit MP performs the following functions in steps 1-11.

In step 1 it is determined whether the preset format allocated to the selected preselection tuning key, i.e. the program identification data stored under this preselection tuning key, such as PI code, PS name, etc. and the emergency list ELx associated with this preselection tuning key must be used or not used. By pressing, for example the preselection tuning key for a short time (1/2-2 seconds) the user can indicate that he wants to tune to a program in accordance with the existing preset format, in which case this existing preset format is compared in step 3 with the program identification data of the received RDS code word. By keeping, for example the preselection tuning key depressed for a slightly longer period (several seconds), the program identification data of the actual RDS transmitter are stored under this key in step 2 and the emergency list ELx associated with this key is erased. Thus, the preset is formatted, or in other words, the existing preset format is changed in step 2.

As stated hereinbefore, the PI code of the existing preset format is compared in step 3 with the PI code of the received RDS code word. If the two PI codes mutually deviate, the PI code of the subsequently received RDS code word is compared with the stored PI code. This so-called PI check is continuously repeated until the two PI codes mutually correspond, whereafter step 4 follows.

In step 4 one waits for the reception of further RDS data, while it is checked in step 5 whether the received RDS data relate to the header of an AF list. Such a header is shown in Fig. 3 and comprises a length indication I as well as the tuning data or the frequency of the associated transmitter AF. The length indication in version B indicates the number of frequencies in the AF list, following the header. These frequencies refer to transmitters whose program is an alternative to the program of said transmitter AF. As long as no header information is received, steps 4 and 5 are repeated.

If header information is received, it is checked in step 6 whether this information has already been stored in the emergency list ELx.

If so, the microprocessor circuit MP returns to step 4. If not, it is checked in step 7 whether the emergency list ELx, which is associated with the relevant preselection tuning key, is entirely filled or not. For the purpose of illustration Fig. 4 diagrammatically shows the emergency list ELx with memory sites 1-n which can be allocated by means of a count i. At each storage of header information the count is raised by 1 as long as the memory ELx is not completely filled, i.e. as long as $i < n$. This is effected in step 8.

In step 8 not only the count i is raised by one but also the length indication I transmitted in the header and the tuning data of the associated alternative frequency (AF) are stored at the location, denoted by the count i, in the emergency list ELx.

If the count i is equal to or larger than n, step 7 is followed by step 9 in which it is checked whether the length indication I in the received header is larger than the smallest length indication of the AFs stored in the emergency list. If this is not the case, step 11 follows. If this is the case, the smallest length indication Imin and the associated AF is replaced in step 10 by the length indication I and the associated AF of the actually received header, followed by step 11.

In step 11 the smallest length indication $I_{min}$ and the associated AF, also referred to as $AF(I_{min})$ is determined, as well as the location, denoted by the count $i_{min}$, in the emergency list ELx in order to enable quick recognition and storage of a main transmitter when a subsequent header is received. Such a selection of main transmitters can also be realised for AFs which are transmitted in accordance with version A by counting the number of AFs of the transmitters to be received in a given country or part thereof (Federal States) instead of by using the length indication I.

It will not be difficult to those skilled in the art to realise the invention by means of a receiver configuration deviating from the version shown in Fig. 1. For example, it is possible to provide the memory banks MB1-MBm, EL1-ELm with mutually deviating numbers of memory sites, mutually combine the functions of the circuits DEM, EC and DEC and/or incorporate them in the microprocessor MP, likewise as the memory sites M1 and M2, etc.

**Claims**

1.  An FM receiver for radio data signals comprising digital tuning data of alternative frequencies of a plurality of transmitters, which receiver comprises a first memory circuit for storing the digital tuning data of at least a part of the alternative frequencies, and a tuning control circuit which sets the tuning of the FM receiver at one of the frequencies in the first memory circuit when a first activation signal is applied, characterized by an arrangement for determining the number of alternative frequencies of each one of said transmitters and for selecting those transmitters whose number of alternative frequencies exceeds a threshold value, and a second memory circuit for storing the tuning data of the last-mentioned transmitters, said tuning control circuit setting the tuning of the FM receiver at one of the frequencies whose tuning data are stored in the second memory circuit when a second activation signal is applied.

2.  An FM receiver as claimed in Claim 1, comprising a detection circuit for measuring the reception quality of the FM signal at the frequencies whose tuning data are stored in the first memory circuit, characterized in that the detection circuit also measures the reception quality of the FM signal at the frequencies whose tuning data are stored in the second memory circuit when the second activation signal is applied, and the tuning circuit sets the tuning of the FM receiver at the frequency in the second memory circuit having the highest reception quality.

3.  An FM receiver as claimed in Claim 1, characterized in that said arrangement also determines the method of transmitting the alternative frequencies and comprises means for deriving the number of alternative frequencies per transmitter from the length indications which are incorporated per transmitter in the headers of the alternative frequency lists in the RDS signals.

4.  An FM receiver as claimed in Claims 1 to 5, characterized in that said threshold value is fixed during filling of the second memory circuit and, when the second memory circuit is completely filled, is equal to the smallest number of alternative frequencies in the second memory circuit, the tuning data of a transmitter selected by said arrangement and the number of alternative frequencies thereof being stored at the location of the transmitter with said smallest number of alternative frequencies when the second memory circuit is completely filled.

FIG.1

EP 0 431 694 A1

FIG.3

FIG.4

$$i_{st} = St_{max} ?$$

$$l \geqslant l_{min} ?$$

$$i_{st} := i_{st}+1$$
$$l_{st} := l$$
$$AF_{st} := AF$$

$$l_{st}(l_{min}) := l$$
$$AF_{st}(l_{min}) := AF$$

FIG.2

European
Patent Office

**EUROPEAN SEARCH
REPORT**

Application Number

**EP 90 20 3181**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 7, no. 148 (E-184)[1293], 29th June 1983; JP-A-58 060 817 (MITSUBISHI DENKI K.K.) 11-04-1983 * Abstract; figure * | 1-4 | H 04 H 1/00 H 03 J 7/18 |
| | — — — | | |
| A | WO-A-8 804 862 (TELEFUNKEN) * Page 2, line 3 - page 3, line 4; page 5, lines 3-22; page 10, line 11 - page 12, line 23; page 15, line 26 - page 16, line 10; figure 1 * | 1-4 | |
| | — — — | | |
| A | EP-A-0 314 995 (BLAUPUNKT) | | |
| | — — — | | |
| A | EP-A-0 092 055 (BLAUPUNKT) * Page 4, lines 16-20; page 8, lines 11-14; page 19, line 4 - page 13, line 9; page 14, line 16 - page 15, line 33; figure 1 * | 1-4 | |
| | — — — — — | | |

| TECHNICAL FIELDS SEARCHED (Int. Cl.5) |
|---|
| H 04 H H 03 J |

The present search report has been drawn up for all claims

| Place of search | Date of completion of search | Examiner |
|---|---|---|
| The Hague | 23 January 91 | ANDERSEN J.G. |